# EUROPEAN PATENT APPLICATION

(11) **EP 4 495 204 A1**
(43) Date of publication of application: **22.01.2025**
(21) Application number: 22938483.9
(22) Date of filing: 20.04.2022
(51) Int. Cl.: C09K 3/14, B24B 37/00, H01L 21/304

(54) **POLISHING AGENT AND POLISHING METHOD**

(71) Applicant: Resonac Corporation, Tokyo 105-7325 (JP)
(72) Inventor: HANANO, Masayuki, Tokyo 105-7325 (JP); KAWAKITA, Junpei, Tokyo 105-7325 (JP); HAGA, Kouji, Tokyo 105-7325 (JP)
(74) Representative: Hoffmann Eitle
(86) International application number: PCT/JP2022/018286
(87) International publication number: WO 2023/203680

(57) **Abstract**

A polishing agent for polishing a surface to be polished containing indium tin oxide, the polishing agent containing abrasive grains, at least one dicarboxylic acid component selected from the group consisting of a dicarboxylic acid having 3 or less carbon atoms and a salt thereof, and water, in which the abrasive grains contain silica and have a positive zeta potential, and a pH is 9.0 or less.

## Description

### Technical Field

The present disclosure relates to a polishing agent, a polishing method, and the like used for polishing indium tin oxide (hereinafter, referred to as "ITO").

### Background Art

In recent years, new microfabrication technologies have been developed along with the tendencies of higher integration or higher performance of semiconductor integrated circuits (hereinafter, referred to as "LSI"). Chemical mechanical polishing (hereinafter, referred to as "CMP") is one of such technologies, and is a technique that is frequently used in the LSI manufacturing process (in particular, flattening of interlayer insulating material, formation of metal plug, formation of buried wiring and the like in multilayer interconnection forming process).

ITO has high light transparency, electrical conductivity, and durability, and thus, is used in flat panel displays and the like. Furthermore, in recent years, ITO has attracted attention as a protective material for an optical element of a semiconductor (see, for example, Patent Literatures 1 and 2 below). CMP can be used for polishing ITO, and a polishing agent used for polishing ITO is known (see, for example, Patent Literature 3 below).

### Citation List

### Patent Literature

Patent Literature 1: Japanese Unexamined Patent Publication No. 2018-125538
Patent Literature 2: Japanese Unexamined Patent Publication No. 2010-114411
Patent Literature 3: Japanese Unexamined Patent Publication No. 2009-526659

### Summary of Invention

### Technical Problem

There is a demand for such a polishing agent used for polishing ITO to further improve a polishing rate for ITO (ITO polishing rate).

An object of an aspect of the present disclosure is to provide a polishing agent capable of obtaining an excellent ITO polishing rate. An object of another aspect of the present disclosure is to provide a polishing method using this polishing agent.

### Solution to Problem

The present inventors have conducted intensive studies, and as a result, have found that an excellent ITO polishing rate can be obtained by using abrasive grains containing silica and having a positive zeta potential, and at least one dicarboxylic acid component selected from the group consisting of a dicarboxylic acid having 3 or less carbon atoms and a salt thereof in a polishing agent having a pH of 9.0 or less.

The present disclosure relates to the following [1] to [15] and the like in several aspects.
[1] A polishing agent for polishing a surface to be polished containing ITO, the polishing agent containing abrasive grains, at least one dicarboxylic acid component selected from the group consisting of a dicarboxylic acid having 3 or less carbon atoms and a salt thereof, and water, in which the abrasive grains contain silica and have a positive zeta potential, and a pH is 9.0 or less.
[2] The polishing agent described in [1], in which the abrasive grains contain colloidal silica.
[3] The polishing agent described in [1] or [2], in which an average particle diameter of the abrasive grains is more than 50 nm.
[4] The polishing agent described in any one of [1] to [3], in which a content of the abrasive grains is 1 to 5% by mass.
[5] The polishing agent described in any one of [1] to [4], in which the dicarboxylic acid component includes at least one selected from the group consisting of oxalic acid and a salt thereof.
[6] The polishing agent described in any one of [1] to [5], in which the dicarboxylic acid component includes at least one selected from the group consisting of malonic acid and a salt thereof.
[7] The polishing agent described in any one of [1] to [6], in which a content of the dicarboxylic acid component is 0.01 to 0.20% by mass.
[8] The polishing agent described in any one of [1] to [7], further containing a cationic surfactant.
[9] The polishing agent described in [8], in which the cationic surfactant includes an ammonium salt.
[10] The polishing agent described in [8] or [9], in which the cationic surfactant includes an ammonium salt having one quaternary nitrogen atom.
[11] The polishing agent described in any one of [8] to [10], in which the cationic surfactant includes an ammonium salt having a carbon-carbon unsaturated bond.
[12] The polishing agent described in any one of [1] to [11], in which the pH is 3.0 to 4.0.
[13] The polishing agent described in any one of [1] to [12], in which the pH is more than 3.0 and 4.0 or less.
[14] A polishing agent containing constituent components of the polishing agent described in any one of [1] to [13] stored while being divided into a first liquid and a second liquid, in which the first liquid contains the abrasive grains and water, and the second liquid contains the dicarboxylic acid component and water.
[15] A polishing method including a step of polishing a surface to be polished containing ITO by using the polishing agent described in any one of [1] to [13].

### Advantageous Effects of Invention

According to an aspect of the present disclosure, it is possible to provide a polishing agent capable of obtaining an excellent ITO polishing rate. According to another aspect of the present disclosure, it is possible to provide a polishing method using this polishing agent.

### Description of Embodiments

Hereinafter, embodiments of the present disclosure will be described. However, the present disclosure is not limited to the following embodiments.

### <Definition>

In the present specification, a numerical range that has been indicated by use of "to" indicates the range that includes the numerical values which are described before and after "to", as the minimum value and the maximum value, respectively. "A or more" in the numerical range means A and a range of more than A. "A or less" in the numerical range means A and a range of less than A. In the numerical ranges that are described stepwise in the present specification, the upper limit value or the lower limit value of the numerical range of a certain stage can be arbitrarily combined with the upper limit value or the lower limit value of the numerical range of another stage. In the numerical ranges that are described in the present specification, the upper limit value or the lower limit value of the numerical range may be replaced with the value shown in Examples. "A or B" may include either one of A and B, and may also include both of A and B. Materials listed as examples in the present specification can be used singly or in combinations of two or more kinds, unless otherwise specified. When a plurality of substances corresponding to each component exist in the composition, the content of each component in the composition means the total amount of the plurality of substances that exist in the composition, unless otherwise specified. The term "step" includes not only an independent step but also a step by which an intended action of the step is achieved, though the step cannot be clearly distinguished from other steps. The term "(meth)acryl" means at least one of acryl and methacryl corresponding thereto. The same applies to other analogous expressions such as "(meth)acryloyl". The term "polishing rate" means a rate at which a material to be polished is removed by polishing (for example, a reduced amount of a thickness of the material to be polished per time; Removal Rate). The term "abrasive grains" means an aggregation of a plurality of particles, and for convenience, one particle constituting the abrasive grains may be referred to as an abrasive grain.

### <Polishing agent>

A polishing agent of the present embodiment is a polishing agent for polishing a surface to be polished containing ITO. The polishing agent of the present embodiment contains abrasive grains, at least one dicarboxylic acid component selected from the group consisting of a dicarboxylic acid having 3 or less carbon atoms and a salt thereof (hereinafter, referred to as "dicarboxylic acid component A"), and water. The abrasive grains in the polishing agent of the present embodiment contain silica and have a positive zeta potential. The pH of the polishing agent of the present embodiment is 9.0 or less.

According to the polishing agent of the present embodiment, an excellent ITO polishing rate can be obtained, and in evaluation in Examples described below, an ITO polishing rate of 50 nm/min or more (preferably 100 nm/min or more) can be obtained. The present inventors speculate the reasons why such a polishing rate is obtainable as follows. However, the reasons are not limited to the contents to be as follows. That is, when the dicarboxylic acid component A coordinates with ITO in the polishing agent having a pH of 9.0 or less, a state where ITO is easily polished is obtained. Further, since the affinity of silica with ITO is higher in the abrasive grains containing silica and having a positive zeta potential than in abrasive grains having a negative zeta potential, a contact frequency between the abrasive grains containing silica and ITO increases. It is presumed that an excellent ITO polishing rate is obtainable by these effects.

According to the polishing agent of the present embodiment, at least a part of ITO can be removed by polishing the surface to be polished containing ITO. According to the present embodiment, it is possible to provide use of the polishing agent for polishing ITO. The polishing agent of the present embodiment can be used as a CMP polishing agent.

### (Abrasive grains)

The polishing agent of the present embodiment contains abrasive grains containing silica. As the abrasive grains containing silica, silica particles (particles containing silica) such as colloidal silica and fumed silica can be used. The abrasive grains may contain colloidal silica from the viewpoint of easily obtaining an excellent ITO polishing rate, the viewpoint of easily suppressing occurrence of polishing scratches, and the viewpoint of easily selecting the particle diameter.

The abrasive grains have a positive zeta potential (positive charge) in the polishing agent. In a case where the zeta potential of the abrasive grains in the polishing agent is measured and the numerical value exceeds 0 mV, it can be determined that the abrasive grains have a positive zeta potential.

The zeta potential of the abrasive grains may be 10 mV or more, 15 mV or more, or 18 mV or more, from the viewpoint of easily obtaining an excellent ITO polishing rate and the viewpoint of easily obtaining favorable storage stability. The upper limit of the zeta potential is not particularly limited, and is, for example, 100 mV or less.

The zeta potential can be measured, for example, with trade name: DELSA NANO C manufactured by Beckman Coulter, Inc. The zeta potential (ζ [mV]) can be measured by obtaining a measurement sample by diluting the polishing agent with pure water so that the scattering intensity of the measurement sample in a zeta potential measuring apparatus is 1.0×10⁴ to 5.0×10⁴ cps ("cps" means counts per second, which is a unit of the number of particles counted), and then placing this measurement sample in a cell for measuring the zeta potential. In order to adjust the scattering intensity to the above-described range, for example, the polishing agent may be diluted such that the content of the abrasive grains is adjusted to 1.7 to 1.8% by mass.

Examples of a method for adjusting the abrasive grains so as to have a positive zeta potential in the polishing agent include a method of controlling a method for producing abrasive grains, a method of adjusting a pH of the polishing agent, and a method of subjecting the abrasive grains to a surface treatment. Generally, silica particles have a negative zeta potential (negative charge) in liquid, but tend to have a positive zeta potential by lowering the pH. Furthermore, as the method of subjecting the abrasive grains to a surface treatment, silica particles can also be subjected to a surface treatment using a coupling agent having a cationic group.

The abrasive grains can contain a constituent material other than silica. Examples of such a constituent material include alumina, ceria, zirconia, and hydroxides of cerium.

The content of silica in the abrasive grains may be 50% by mass or more, more than 50% by mass, 60% by mass or more, 70% by mass or more, 80% by mass or more, 90% by mass or more, 95% by mass or more, 98% by mass or more, or 99% by mass or more, on the basis of the total mass of the abrasive grains (the whole abrasive grains contained in the polishing agent), from the viewpoint of easily obtaining an excellent ITO polishing rate and the viewpoint of easily suppressing occurrence of polishing scratches. The abrasive grains may be an embodiment composed of silica (substantially 100% by mass of the abrasive grains contained in the polishing agent is silica).

The average particle diameter (average secondary particle diameter) of the abrasive grains may be 10 nm or more, 20 nm or more, 30 nm or more, 40 nm or more, 50 nm or more, more than 50 nm, or 60 nm or more, from the viewpoint that a sufficient mechanical polishing force is easily obtained, and therefore, an excellent ITO polishing rate is easily obtained. The average particle diameter of the abrasive grains may be 200 nm or less, 180 nm or less, 150 nm or less, 120 nm or less, 100 nm or less, 80 nm or less, 70 nm or less, or 60 nm or less, from the viewpoint of easily obtaining favorable dispersion stability of the abrasive grains. From these viewpoints, the average particle diameter of the abrasive grains may be 10 to 200 nm, 20 to 100 nm, or 30 to 80 nm.

The average particle diameter of the abrasive grains can be measured by a photon correlation method. For example, the average particle diameter can be measured with device name: Delsa MAX Pro manufactured by Beckman Coulter, Inc., or the like. A measurement method using Delsa MAX Pro is as described below. For example, an aqueous dispersion in which the content of the abrasive grains is 2.0% by mass is prepared, about 4 mL (L represents "liter"; the same applies hereinafter) of this aqueous dispersion is introduced into a 1-cm square cell, and then the cell is placed in the apparatus. A value obtainable by setting a refractive index and a viscosity of a dispersion medium to 1.33 and 0.887 mPa·s and performing measurement at 25°C can be adopted as the average particle diameter of the abrasive grains.

The content of the abrasive grains may be in the following range on the basis of the total mass of the polishing agent. The content of the abrasive grains may be 0.1% by mass or more, 0.5% by mass or more, 1.0% by mass or more, more than 1.0% by mass, 1.5% by mass or more, 2.0% by mass or more, more than 2.0% by mass, 2.5% by mass or more, 3.0% by mass or more, 3.5% by mass or more, 4.0% by mass or more, 4.5% by mass or more, or 5.0% by mass or more, from the viewpoint that a sufficient mechanical polishing force is easily obtained, and therefore, an excellent ITO polishing rate is easily obtained. The content of the abrasive grains may be 20% by mass or less, 15% by mass or less, 10% by mass or less, 8.0% by mass or less, 6.0% by mass or less, 5.0% by mass or less, less than 5.0% by mass, 4.5% by mass or less, 4.0% by mass or less, 3.5% by mass or less, 3.0% by mass or less, 2.5% by mass or less, or 2.0% by mass or less, from the viewpoint of easily avoiding an increase in viscosity of the polishing agent, the viewpoint of easily avoiding the aggregation of the abrasive grains, the viewpoint of easily suppressing occurrence of polishing scratches, the viewpoint of easily handling the polishing agent, and the like. From these viewpoints, the content of the abrasive grains may be 0.1 to 20% by mass, 0.5 to 10% by mass, 1 to 6% by mass, or 1 to 5% by mass.

### (Acid component)

The polishing agent of the present embodiment contains, as an acid component, at least one dicarboxylic acid component A selected from the group consisting of a dicarboxylic acid having 3 or less carbon atoms and a salt thereof from the viewpoint of obtaining an excellent ITO polishing rate. It is presumed that a dicarboxylic acid having 4 or more carbon atoms and a salt thereof are sterically hindered and are difficult to coordinate with ITO. It is presumed that a carboxylic acid not corresponding to a dicarboxylic acid and a salt thereof are difficult to coordinate with ITO because a chelating effect is not obtainable.

Examples of the dicarboxylic acid component A include oxalic acid, malonic acid, and salts thereof. Examples of the salt include alkali metal salts (for example, a sodium salt). The dicarboxylic acid component A may include at least one selected from the group consisting of oxalic acid, malonic acid, and salts thereof from the viewpoint of easily obtaining an excellent ITO polishing rate. The dicarboxylic acid component A may include at least one selected from the group consisting of oxalic acid and a salt thereof, and may include at least one selected from the group consisting of malonic acid and a salt thereof.

The polishing agent of the present embodiment may contain an acid component other than the dicarboxylic acid component A. Examples of such an acid component include an organic acid component and an inorganic acid component. Examples of the organic acid component include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, succinic acid, adipic acid, glutaric acid, malic acid, citric acid, pimelic acid, maleic acid, phthalic acid, pyruvic acid, lactic acid, glycine, asparagine, α-alanine, β-alanine, glutamic acid, glutamine, valine, leucine, isoleucine, lysine, serine, threonine, phenylalanine, tyrosine, methionine, tryptophan, and salts thereof (for example, alkali metal salts such as a sodium salt). Examples of the inorganic acid component include nitric acid, sulfuric acid, and phosphoric acid. The acid component may be used as a pH adjusting agent that adjusts the pH of the polishing agent.

The content of the dicarboxylic acid component A in an acid component may be 50% by mass or more, more than 50% by mass, 60% by mass or more, 70% by mass or more, 80% by mass or more, 90% by mass or more, 95% by mass or more, 98% by mass or more, or 99% by mass or more, on the basis of the total mass of an acid component (the whole acid component contained in the polishing agent), from the viewpoint of easily obtaining an excellent ITO polishing rate. The acid component may be an embodiment composed of the dicarboxylic acid component A (substantially 100% by mass of the acid component contained in the polishing agent is the dicarboxylic acid component A).

The content of an acid component (the total amount of the compounds corresponding to an acid component) or the content of the dicarboxylic acid component A may be in the following range on the basis of the total mass of the polishing agent from the viewpoint of easily obtaining an excellent ITO polishing rate. The content of an acid component or the content of the dicarboxylic acid component A may be 0.001% by mass or more, 0.005% by mass or more, 0.01% by mass or more, 0.02% by mass or more, 0.03% by mass or more, 0.04% by mass or more, 0.05% by mass or more, 0.08% by mass or more, 0.10% by mass or more, 0.12% by mass or more, or 0.14% by mass or more. The content of an acid component or the content of the dicarboxylic acid component A may be 5.0% by mass or less, 4.0% by mass or less, 3.0% by mass or less, 2.0% by mass or less, 1.0% by mass or less, 0.80% by mass or less, 0.50% by mass or less, 0.40% by mass or less, 0.30% by mass or less, 0.20% by mass or less, 0.15% by mass or less, 0.14% by mass or less, 0.12% by mass or less, or 0.10% by mass or less. From these viewpoints, the content of an acid component or the content of the dicarboxylic acid component A may be 0.001 to 5.0% by mass, 0.005 to 1.0% by mass, 0.01 to 0.30% by mass, or 0.01 to 0.20% by mass.

The content of an acid component or the dicarboxylic acid component A may be in the following range with respect to 100 parts by mass of the abrasive grains. The content of an acid component or the dicarboxylic acid component A may be 0.1 parts by mass or more, 0.5 parts by mass or more, 1.0 part by mass or more, 1.2 parts by mass or more, 1.5 parts by mass or more, 1.8 parts by mass or more, 2.0 parts by mass or more, 2.3 parts by mass or more, 2.5 parts by mass or more, or 2.8 parts by mass or more, from the viewpoint of easily obtaining an excellent ITO polishing rate. The content of an acid component or the dicarboxylic acid component A may be 10 parts by mass or less, 8.0 parts by mass or less, 6.0 parts by mass or less, 5.0 parts by mass or less, 4.0 parts by mass or less, 3.0 parts by mass or less, or 2.8 parts by mass or less, from the viewpoint of easily obtaining an excellent ITO polishing rate. The content of an acid component or the dicarboxylic acid component A may be 2.5 parts by mass or less, 2.3 parts by mass or less, or 2.0 parts by mass or less, from the viewpoint of adjusting an ITO polishing rate. From these viewpoints, the content of an acid component or the dicarboxylic acid component A may be 0.1 to 10 parts by mass, 0.5 to 5.0 parts by mass, or 1.0 to 3.0 parts by mass.

### (Cationic surfactant)

The polishing agent of the present embodiment can contain a cationic surfactant (excluding a compound corresponding to an acid component) from the viewpoint of easily obtaining an excellent ITO polishing rate.

Examples of the cationic surfactant include onium salts such as an ammonium salt and a phosphonium salt. The cationic surfactant may include an onium salt (such as an ammonium salt) having a carbon-carbon unsaturated bond (such as a carbon-carbon unsaturated double bond). The number of carbon-carbon unsaturated bonds in the onium salt (such as an ammonium salt) having a carbon-carbon unsaturated bond may be 1 or 2.

Examples of the counter anion of the onium salt include a halide ion (such as a chloride ion or a bromide ion), a sulfate ion, an alkyl sulfate ion, and a nitrate ion. The counter anion may be at least one selected from the group consisting of a halide ion and an alkyl sulfate ion, and may be a halide ion, from the viewpoint of easily obtaining an excellent ITO polishing rate. The halide ion may be at least one selected from the group consisting of a chloride ion and a bromide ion, and may be a chloride ion, from the viewpoint of easily obtaining an excellent ITO polishing rate. The cationic surfactant may include an onium salt having one counter anion, and may include an ammonium salt having one counter anion, from the viewpoint of easily obtaining an excellent ITO polishing rate.

The cationic surfactant may include an ammonium salt, may include an ammonium salt having one or two nitrogen atoms (a compound having one or two nitrogen atoms), and may include an ammonium salt having one quaternary nitrogen atom (a compound having one quaternary nitrogen atom), from the viewpoint of easily obtaining an excellent ITO polishing rate.

The ammonium salt may have, as a functional group bonded to the nitrogen atom, an alkyl group, an unsaturated hydrocarbon group (such as an allyl group), and an aromatic group (such as a phenyl group). The ammonium salt may include an alkylammonium salt from the viewpoint of easily obtaining an excellent ITO polishing rate.

The alkyl group of the alkylammonium salt may unsubstituted or substituted. Examples of the substituent of the alkyl group include a hydroxy group, an alkoxy group, a carboxy group, a carboxylate group, an amide group, a (meth)acrylamide group, and a (meth)acryloyloxy group. The ammonium salt may include an alkylammonium salt having an alkyl group substituted with a (meth)acrylamide group from the viewpoint of easily obtaining an excellent ITO polishing rate.

In the alkylammonium salt, the number of unsubstituted alkyl groups (alkyl groups bonded to nitrogen atoms) or the number of unsubstituted methyl groups (methyl groups bonded to nitrogen atoms) may be 1 to 4, 2 to 4, 3 to 4, or 2 to 3, from the viewpoint of easily obtaining an excellent ITO polishing rate.

Examples of the alkylammonium salt include tetraalkylammonium salts such as a tetramethylammonium salt, a tetraethylammonium salt, a tetrapropylammonium salt, a (3-acrylamidopropyl)trimethylammonium salt, and 2-((meth)acryloyloxy)ethyltrimethylammonium salt (for example, a methacroylcholine salt); a trialkylammonium salt; a dialkylammonium salt; diallyldialkylammonium salts such as a diallyldimethylammonium salt; and a monoalkylammonium salt. The cationic surfactant may include at least one selected from the group consisting of a tetraalkylammonium salt and a diallyldialkylammonium salt from the viewpoint of easily obtaining an excellent ITO polishing rate.

Examples of the phosphonium salt include a tetramethylphosphonium salt, a tetraethylphosphonium salt, and a tetraphenylphosphonium salt.

The cationic surfactant may include a compound (such as an ammonium salt) having the following molecular weight from the viewpoint of easily obtaining an excellent ITO polishing rate. The molecular weight may be 500 or less, 450 or less, 400 or less, 350 or less, 300 or less, 250 or less, 220 or less, 200 or less, 180 or less, 150 or less, or 120 or less. The molecular weight may be 50 or more, 80 or more, 100 or more, 120 or more, 150 or more, 180 or more, or 200 or more. From these viewpoints, the molecular weight may be 50 to 500, 80 to 400, or 100 to 250.

The content of the ammonium salt in the cationic surfactant may be 50% by mass or more, more than 50% by mass, 60% by mass or more, 70% by mass or more, 80% by mass or more, 90% by mass or more, 95% by mass or more, 98% by mass or more, or 99% by mass or more, on the basis of the total mass of the cationic surfactant (the whole cationic surfactant contained in the polishing agent), from the viewpoint of easily obtaining an excellent ITO polishing rate. The cationic surfactant may be an embodiment composed of the ammonium salt (substantially 100% by mass of the cationic surfactant contained in the polishing agent is the ammonium salt).

The content of the cationic surfactant may be in the following range on the basis of the total mass of the polishing agent. The content of the cationic surfactant may be 0.005% by mass or more, 0.01% by mass or more, 0.03% by mass or more, 0.05% by mass or more, 0.06% by mass or more, 0.08% by mass or more, or 0.10% by mass or more, from the viewpoint of easily obtaining an excellent ITO polishing rate. The content of the cationic surfactant may be 5.0% by mass or less, 3.0% by mass or less, 1.0% by mass or less, 0.80% by mass or less, 0.50% by mass or less, 0.30% by mass or less, 0.20% by mass or less, or 0.10% by mass or less, from the viewpoint of easily obtaining an excellent ITO polishing rate and the viewpoint of easily preventing the aggregation of the abrasive grains. The content of the cationic surfactant may be 0.08% by mass or less or 0.06% by mass or less, from the viewpoint of adjusting an ITO polishing rate. From these viewpoints, the content of the cationic surfactant may be 0.005 to 5.0% by mass, 0.01 to 1.0% by mass, or 0.05 to 0.50% by mass. The content of the cationic surfactant may be 0.01% by mass or less, 0.001% by mass or less, or 0.0001% by mass or less, and may be substantially 0% by mass (the polishing agent of the present embodiment may not contain a cationic surfactant).

The content of the cationic surfactant may be in the following range with respect to 100 parts by mass of the abrasive grains. The content of the cationic surfactant may be 0.1 parts by mass or more, 0.5 parts by mass or more, 1.0 part by mass or more, 1.2 parts by mass or more, 1.5 parts by mass or more, 1.8 parts by mass or more, or 2.0 parts by mass or more, from the viewpoint of easily obtaining an excellent ITO polishing rate. The content of the cationic surfactant may be 2.3 parts by mass or more, 2.5 parts by mass or more, 2.8 parts by mass or more, or 3.0 parts by mass or more, from the viewpoint of adjusting an ITO polishing rate. The content of the cationic surfactant may be 10 parts by mass or less, 8.0 parts by mass or less, 6.0 parts by mass or less, 5.0 parts by mass or less, 4.0 parts by mass or less, 3.0 parts by mass or less, 2.8 parts by mass or less, 2.5 parts by mass or less, 2.3 parts by mass or less, or 2.0 parts by mass or less, from the viewpoint of easily obtaining an excellent ITO polishing rate and the viewpoint of preventing the aggregation of the abrasive grains. The content of the cationic surfactant may be 1.8 parts by mass or less, 1.5 parts by mass, or 1.2 parts by mass, from the viewpoint of adjusting an ITO polishing rate. From these viewpoints, the content of the cationic surfactant may be 0.1 to 10 parts by mass, 0.5 to 5.0 parts by mass, or 1.0 to 3.0 parts by mass. The content of the cationic surfactant may be 0.01 parts by mass or less, 0.001 parts by mass or less, or 0.0001 parts by mass or less, and may be substantially 0 parts by mass.

The content of the cationic surfactant may be in the following range with respect to 100 parts by mass of an acid component or the dicarboxylic acid component A. The content of the cationic surfactant may be 1 part by mass or more, 5 parts by mass or more, 10 parts by mass or more, 20 parts by mass or more, 30 parts by mass or more, 40 parts by mass or more, 50 parts by mass or more, 60 parts by mass or more, or 70 parts by mass or more, from the viewpoint of easily obtaining an excellent ITO polishing rate. The content of the cationic surfactant may be 80 parts by mass or more, 100 parts by mass or more, 120 parts by mass or more, or 150 parts by mass or more, from the viewpoint of adjusting an ITO polishing rate. The content of the cationic surfactant may be 500 parts by mass or less, 400 parts by mass or less, 300 parts by mass or less, 250 parts by mass or less, 200 parts by mass or less, 150 parts by mass or less, 120 parts by mass or less, 100 parts by mass or less, or 80 parts by mass or less, from the viewpoint of easily obtaining an excellent ITO polishing rate. The content of the cationic surfactant may be 70 parts by mass or less, or 60 parts by mass or less, from the viewpoint of adjusting an ITO polishing rate. From these viewpoints, the content of the cationic surfactant may be 1 to 500 parts by mass, 10 to 300 parts by mass, or 50 to 200 parts by mass. The content of the cationic surfactant may be 0.1 parts by mass or less, 0.01 parts by mass or less, or 0.001 parts by mass or less, and may be substantially 0 parts by mass.

### (Water)

The polishing agent of the present embodiment contains water. The water can be used as a dispersion medium of other components or as a solvent. Impurities in the water may be reduced in order to prevent them from interfering with the action of the other components. Examples of the water include pure water and ultrapure water from which impurity ions are removed by an ion-exchange resin and then foreign substances are removed through a filter; and distilled water.

### (Other additives)

The polishing agent of the present embodiment may contain other additives as components different from the abrasive grains, an acid component, a cationic surfactant, and water. Such additives may be used for the purposes of improvement in the dispersibility of the abrasive grains in the polishing agent, improvement in the chemical stability of the polishing agent, improvement in the polishing rate, and the like. Examples of the additives include a base component, an organic solvent, a corrosion inhibitor, and an antifoaming agent. The content of the additives in the polishing agent can be arbitrarily determined.

Examples of the base component include ammonia, sodium hydroxide, potassium hydroxide, and TMAH (tetramethylammonium hydroxide).

Examples of the organic solvent include carbonate esters such as ethylene carbonate, propylene carbonate, dimethyl carbonate, diethyl carbonate, and methyl ethyl carbonate; lactones such as butyrolactone and propiolactone; glycols such as ethylene glycol, propylene glycol, diethylene glycol, dipropylene glycol, triethylene glycol, tripropylene glycol, methanediol, propanediol, butanediol, pentanediol, hexanediol, heptanediol, octanediol, nonanediol, decanediol, butanetriol, pentanetriol, hexanetriol, heptanetriol, octanetriol, nonanetriol, decanetriol, and erythritol; and derivatives of glycols such as glycol monoethers such as ethylene glycol monomethyl ether, propylene glycol monomethyl ether, diethylene glycol monomethyl ether, dipropylene glycol monomethyl ether, triethylene glycol monomethyl ether, tripropylene glycol monomethyl ether, ethylene glycol monoethyl ether, propylene glycol monoethyl ether, diethylene glycol monoethyl ether, dipropylene glycol monoethyl ether, triethylene glycol monoethyl ether, tripropylene glycol monoethyl ether, ethylene glycol monopropyl ether, propylene glycol monopropyl ether, diethylene glycol monopropyl ether, dipropylene glycol monopropyl ether, triethylene glycol monopropyl ether, tripropylene glycol monopropyl ether, ethylene glycol monobutyl ether, propylene glycol monobutyl ether, diethylene glycol monobutyl ether, dipropylene glycol monobutyl ether, triethylene glycol monobutyl ether, and tripropylene glycol monobutyl ether, and glycol diethers such as ethylene glycol dimethyl ether, propylene glycol dimethyl ether, diethylene glycol dimethyl ether, dipropylene glycol dimethyl ether, triethylene glycol dimethyl ether, tripropylene glycol dimethyl ether, ethylene glycol diethyl ether, propylene glycol diethyl ether, diethylene glycol diethyl ether, dipropylene glycol diethyl ether, triethylene glycol diethyl ether, tripropylene glycol diethyl ether, ethylene glycol dipropyl ether, propylene glycol dipropyl ether, diethylene glycol dipropyl ether, dipropylene glycol dipropyl ether, triethylene glycol dipropyl ether, tripropylene glycol dipropyl ether, ethylene glycol dibutyl ether, propylene glycol dibutyl ether, diethylene glycol dibutyl ether, dipropylene glycol dibutyl ether, triethylene glycol dibutyl ether, and tripropylene glycol dibutyl ether.

Examples of the metal corrosion inhibitor include a triazole compound (a compound having a triazole skeleton), a pyridine compound, a pyrazole compound, a pyrimidine compound, an imidazole compound, a guanidine compound, a thiazole compound, a tetrazole compound, a triazine compound, and hexamethylenetetramine.

### (pH of polishing agent)

The pH of the polishing agent of the present embodiment is 9.0 or less from the viewpoint of obtaining an excellent ITO polishing rate. The pH of the polishing agent may be 8.0 or less, 7.0 or less, less than 7.0, 6.0 or less, 5.0 or less, 4.0 or less, 3.5 or less, 3.3 or less, or 3.2 or less, from the viewpoint of easily obtaining an excellent ITO polishing rate and the viewpoint of easily obtaining favorable dispersion stability of the abrasive grains. The pH of the polishing agent may be 3.1 or less, 3.0 or less, less than 3.0, 2.9 or less, 2.8 or less, or 2.6 or less, from the viewpoint of adjusting an ITO polishing rate. The pH of the polishing agent may be 1.0 or more, 1.5 or more, 2.0 or more, more than 2.0, 2.5 or more, 2.6 or more, 2.8 or more, 2.9 or more, 3.0 or more, more than 3.0, 3.1 or more, or 3.2 or more, from the viewpoint that a sufficient mechanical polishing force is easily obtained, and therefore, an excellent ITO polishing rate is easily obtained. From these viewpoints, the pH of the polishing agent may be 1.0 to 9.0, 2.0 to 7.0, 2.5 to 5.0, 2.9 to 5.0, 3.0 to 4.0, or more than 3.0 and 4.0 or less. The pH of the polishing agent may be adjusted, for example, by the above-described acid component, the base component, or the like. The pH of the polishing agent is defined as the pH at a liquid temperature of 25°C.

The pH of the polishing agent can be measured by a pH meter (for example, trade name: Model (F-51) manufactured by HORIBA, Ltd.) using a general glass electrode. The pH of the polishing agent is obtained, for example, calibrating the pH meter by three points using a pH standard solution (pH 4.01) of a phthalate, a pH standard solution (pH 6.86) of a neutral phosphate, and a pH standard solution (pH 9.18) of a borate as pH standard solutions, then putting an electrode of the pH meter in the polishing agent, and measuring a value at the time after 2 minutes or longer elapsed and the pH became stable. At this time, the liquid temperatures of the pH standard solution and the polishing agent are, for example, 25°C.

### (Storage form of polishing agent)

The polishing agent of the present embodiment may be stored as a one-pack type polishing agent containing the abrasive grains, the dicarboxylic acid component A, and water, may be stored as a stock solution for a polishing agent for obtaining a one-pack type polishing agent by being diluted with water, and may be stored as a multi-pack type polishing agent in which constituent components of a one-pack type polishing agent is divided into a plurality of liquids.

The one-pack type polishing agent can be obtained by diluting the stock solution for a polishing agent with water before use or at the time of use. The stock solution for a polishing agent is different from the one-pack type polishing agent in that the content of water is smaller than that in the one-pack type polishing agent. The dilution ratio may be, for example, 1.5 times or more (when the one-pack type polishing agent is obtained by adding water to the stock solution for a polishing agent, dilution may be performed such that the mass of the one-pack type polishing agent is 1.5 times the mass of the stock solution for a polishing agent).

In the multi-pack type polishing agent, it is possible to enhance the liquid stability of the polishing agent, and it is possible to reduce cost, space, and the like required for transportation, storage, and the like of the polishing agent. In the multi-pack type polishing agent, for example, constituent components of the one-pack type polishing agent may be divided into a first liquid and a second liquid such that the first liquid and the second liquid are mixed to obtain the one-pack type polishing agent. The multi-pack type polishing agent has, for example, a first liquid containing the abrasive grains and water and a second liquid containing the dicarboxylic acid component A and water. Components other than the abrasive grains, the dicarboxylic acid component A, and water can be appropriately contained in the first liquid, the second liquid, or other liquid, and can be contained, for example, in the second liquid. The polishing agent may be prepared by mixing the first liquid and the second liquid of the multi-pack type polishing agent immediately before use or at the time of polishing, and the polishing agent may be prepared by supplying each of the first liquid and the second liquid of the multi-pack type polishing agent onto a polishing platen and mixing the first liquid and the second liquid on the polishing platen. The constituent components of the one-pack type polishing agent may be stored separately in three or more liquids.

### <Polishing method>

A polishing method of the present embodiment includes a polishing step (for example, a CMP step) of polishing a surface to be polished containing ITO (indium tin oxide) by using the polishing agent of the present embodiment. In the polishing step, at least a part of ITO can be removed. The polishing agent used in the polishing step may be a one-pack type polishing agent, may be a polishing agent obtained by diluting a stock solution for a polishing agent with water, and may be a polishing agent obtained by mixing a plurality of liquids (such as the first liquid and the second liquid) of the multi-pack type polishing agent.

In the polishing method of the present embodiment, a base substrate having a surface to be polished containing ITO can be polished. The base substrate may have, for example, an ITO member (a member containing ITO) having recesses and protrusions on a surface thereof and other members (for example, members containing an insulating material, a metal material, or the like). In the polishing step, an ITO member of a base substrate having the ITO member and an insulating member (a member containing an insulating material) may be polished by using the polishing agent of the present embodiment and polishing may be stopped when the insulating member is exposed.

In the polishing step, for example, the surface to be polished of the base substrate can be polished by relatively moving the base substrate with respect to the polishing platen in such a state that the surface to be polished of the base substrate is pressed against a polishing cloth (polishing pad) of the polishing platen, the polishing agent is supplied between the surface to be polished and the polishing cloth, and a predetermined pressure is applied to the rear face (surface opposite to surface to be polished) of the base substrate.

As a polishing apparatus, for example, it is possible to use a general polishing apparatus which has a polishing platen to which a motor that can change the number of revolutions or the like is attached and on which a polishing cloth also can be mounted; and a holder which holds the base substrate. The polishing cloth is not particularly limited, but a general nonwoven fabric, foamed polyurethane, a porous fluororesin, and the like can be used. The polishing conditions are not particularly limited, but the rotational speed of the polishing platen may be a low rotation of 200 rpm (rpm = min⁻¹) or less to suppress the flying-off of the base substrate. During polishing, the polishing agent may be continuously supplied to the polishing cloth with a pump or the like. The supply amount of the polishing agent is not limited, but the surface of the polishing cloth may be covered with the polishing agent at all times and a product produced by a progress of polishing may be continuously discharged.

The polishing method of the present embodiment may include a step of preparing a base substrate to be polished before the polishing step.

In the case of using the stock solution for a polishing agent, the polishing method of the present embodiment may include a polishing agent preparation step of diluting the stock solution for a polishing agent with water to obtain the polishing agent, before the polishing step. In the case of using the multi-pack type polishing agent, the polishing method of the present embodiment may include a polishing agent preparation step of mixing the plurality of liquids (the first liquid, the second liquid, and the like) of the multi-pack type polishing agent to obtain the polishing agent, before the polishing step.

The polishing method of the present embodiment may include a conditioning step of a polishing cloth before the polishing step from the viewpoint of performing polishing with a consistent surface condition of the polishing cloth. In the conditioning step, for example, the conditioning of the polishing cloth can be performed with a liquid containing at least water, while using a dresser to which diamond particles attach.

The polishing method of the present embodiment may include a base substrate washing step after the polishing step. The base substrate after the completion of polishing may be adequately washed in running water, and then dried after removing droplets, which have attached onto the base substrate, with the use of a spin dry or the like. Furthermore, the base substrate may be washed by a known washing method (for example, a method of removing the deposits on the base substrate by pressing a polyurethane brush against the base substrate with a constant pressure while letting a commercially available washing liquid flow on the surface of the base substrate and rotating the brush), and then dried.

A method of producing a component of the present embodiment includes an individually dividing step of dividing a base substrate polished by the polishing method of the present embodiment into individual pieces. The individually dividing step may be, for example, a step of dicing a wafer (for example, a semiconductor wafer) polished by the polishing method of the present embodiment to obtain chips (for example, semiconductor chips). The method of producing a component of the present embodiment may include a polishing step of polishing a base substrate by the polishing method of the present embodiment before the individually dividing step. A component of the present embodiment may be, for example, a chip (for example, a semiconductor chip). The component of the present embodiment is a component obtained by the method of producing a component of the present embodiment. An electronic device of the present embodiment has the component of the present embodiment.

### Examples

Hereinafter, the present disclosure will be more specifically described by means of Examples; however, the present disclosure is not limited to these Examples.

### <Preparation of polishing agent>

The acid component of Table 1 or Table 2 was added in a container (the cationic surfactant of Table 1 or Table 2 was also added in Examples 3 to 10 and Comparative Examples 1, 4, and 5). Thereafter, 60 parts by mass of ultrapure water was added thereto to obtain a mixture, and then this mixture was stirred to dissolve each component. Next, abrasive grains (colloidal silica) were added, and then ultrapure water (X parts by mass) was added thereto to obtain 100 parts by mass of a polishing agent. In Examples 1 to 3 and 5 to 10 and Comparative Examples 1, 2, 4, and 5, a 10% potassium hydroxide (KOH) aqueous solution as a pH adjusting agent was added after adding the abrasive grains (colloidal silica) and before adding the ultrapure water. The blending amount of the potassium hydroxide aqueous solution was adjusted so as to obtain the pH of Table 1 or Table 2. The blending amount (X parts by mass) of the ultrapure water was adjusted so as to obtain 100 parts by mass of the polishing agent.

The number of carbon atoms and the number of carboxy groups in each acid component are as follows.
Oxalic acid: the number of carbon atoms: 2, the number of carboxy groups: 2
Malonic acid: the number of carbon atoms: 3, the number of carboxy groups: 2
Pyruvic acid: the number of carbon atoms: 3, the number of carboxy groups: 1
Lactic acid: the number of carbon atoms: 3, the number of carboxy groups: 1
Succinic acid: the number of carbon atoms: 4, the number of carboxy groups: 2
Glutaric acid: the number of carbon atoms: 5, the number of carboxy groups: 2

As the cationic surfactant, the following compounds were used.
Ammonium salt A: Diallyldimethylammonium chloride, manufactured by Tokyo Chemical Industry Co., Ltd.
Ammonium salt B: Tetramethylammonium bromide, manufactured by Tokyo Chemical Industry Co., Ltd.
Ammonium salt C: Methacroylcholine chloride (also known as: 2-(methacryloyloxy)ethyltrimethylammonium chloride), manufactured by Tokyo Chemical Industry Co., Ltd.
Ammonium salt D: (3-Acrylamidepropyl)trimethylammonium chloride, manufactured by Tokyo Chemical Industry Co., Ltd.
Ammonium salt E: 2-(Methacryloyloxy)ethyltrimethylammonium methylsulfate, manufactured by FUJIFILM Wako Chemical Corporation

### <Measurement of average particle diameter of abrasive grains>

The average particle diameter of the abrasive grains was measured by using Delsa MAX Pro manufactured by Beckman Coulter, Inc. First, an aqueous dispersion in which the content of the abrasive grains was 2.0% by mass was prepared by using the above-described polishing agent. About 4 mL of this aqueous dispersion was introduced into a 1-cm square cell, and then the cell was placed in the apparatus. The average particle diameter of the abrasive grains was measured by setting a refractive index and a viscosity of a dispersion medium to 1.33 and 0.887 mPa·s and performing measurement at 25°C. In all of Examples and Comparative Examples, the average particle diameter (secondary particle diameter) of the abrasive grains was 60 nm.

### <Measurement of zeta potential of abrasive grains>

The zeta potential of the abrasive grains in the polishing agent was measured by using a zeta potential measuring apparatus (trade name: DELSA NANO C manufactured by Beckman Coulter, Inc.). A sample was obtained by diluting the polishing agent with pure water so that the scattering intensity of the measurement sample became 1.0×10⁴ to 5.0×10⁴ cps in the zeta potential measuring apparatus. After that, the sample was placed in a cell for measuring the zeta potential, and the zeta potential was measured. In all of Examples and Comparative Examples, the surfaces of the abrasive grains were positively charged in the polishing agent.

### <Measurement of pH of polishing agent>

The pH of the polishing agent was evaluated under the following conditions. The results are shown in Table 1 and Table 2.
Measurement temperature: 25 ± 5°C
Measuring apparatus: trade name: Model (F-51) manufactured by HORIBA, Ltd.
Measurement method: calibrating the pH meter by three points using a pH standard solution (pH 4.01) of a phthalate, a pH standard solution (pH 6.86) of a neutral phosphate, and a pH standard solution (pH 9.18) of a borate as pH standard solutions, then putting an electrode of the pH meter in the polishing agent, and measuring the pH with the measuring apparatus at the time after 2 minutes or longer elapsed and the pH became stable.

### <Evaluation of polishing properties>

As the base substrate to be polished, a base substrate obtained by cutting a laminate having a 200 nm-thick ITO film on a silicon substrate into a 2 cm square was used. The above-described base substrate was fixed to a holder (a holder to which an adsorption pad for mounting a base substrate was attached) of a polishing apparatus (manufactured by NANO FACTOR, FACT-200). The holder was placed on a polishing platen to which a foamed polyurethane polishing cloth was attached such that the ITO film faced the polishing cloth. A weight was placed thereon so that the processing load was adjusted to 0.34 kgf/cm². While the above-described polishing agent was dropped onto the polishing platen at 15 mL/min, the ITO film was polished for 30 seconds at a platen rotation speed of 90 min⁻¹ and a head rotation speed of 87 min⁻¹. The ITO polishing rate was calculated from a difference in film thickness obtained by measuring the film thicknesses of the ITO film before and after polishing. For the measurement of the film thickness, a film thickness measuring apparatus (F40 manufactured by Filmetrics, INC.) was used. The results are shown in Table 1 and Table 2. In Examples, it was confirmed that an excellent ITO polishing rate was obtained.

**[Table 1]**

| | | Example | | | | | | | | | |
|---|---|---|---|---|---|---|---|---|---|---|---|
| | | 1 | 2 | 3 | 4 | 5 | 6 | 7 | 8 | 9 | 10 |
| Abrasive grains | | 5 | 5 | 5 | 5 | 5 | 5 | 5 | 5 | 5 | 2 |
| Acid component | Oxalic acid | 0.10 | - | 0.10 | 0.14 | 0.10 | 0.10 | 0.10 | 0.10 | 0.10 | 0.04 |
| | Malonic acid | - | 0.10 | - | - | - | - | - | - | - | - |
| Cationic surfactant | Ammonium salt A | - | - | 0.06 | 0.10 | 0.10 | - | - | - | - | 0.06 |
| | Ammonium salt B | - | - | - | - | - | 0.10 | - | - | - | - |
| | Ammonium salt C | - | - | - | - | - | - | 0.10 | - | - | - |
| | Ammonium salt D | - | - | - | - | - | - | - | 0.10 | - | - |
| | Ammonium salt E | - | - | - | - | - | - | - | - | 0.10 | - |
| pH adjusting agent | KOH | 0.034 | 0.045 | 0.034 | - | 0.017 | 0.034 | 0.034 | 0.034 | 0.034 | 0.014 |
| pH of polishing agent | | 3.0 | 3.0 | 3.1 | 3.2 | 2.6 | 3.1 | 3.1 | 3.1 | 3.1 | 3.1 |
| ITO polishing rate [nm/min] | | 173 | 127 | 208 | 215 | 83 | 225 | 218 | 232 | 209 | 152 |

**[Table 2]**

| | | Comparative Example | | | | |
|---|---|---|---|---|---|---|
| | | 1 | 2 | 3 | 4 | 5 |
| Abrasive grains | | 5 | 5 | 5 | 2 | 2 |
| Acid component | Oxalic acid | 0.30 | - | - | - | - |
| | Pyruvic acid | - | 0.18 | - | - | - |
| | Lactic acid | - | - | 0.24 | - | - |
| | Succinic acid | - | - | - | 0.05 | - |
| | Glutaric acid | - | - | - | - | 0.05 |
| Cationic surfactant | Ammonium salt A | 0.10 | - | - | 0.10 | 0.10 |
| pH adjusting agent | KOH | 0.465 | 0.033 | - | 0.011 | 0.002 |
| pH of polishing agent | | 10 | 3.1 | 3.1 | 3.1 | 3.1 |
| ITO polishing rate [nm/min] | | 18 | 24 | 11 | 16 | 11 |

## Claims

1. A polishing agent for polishing a surface to be polished containing indium tin oxide, the polishing agent comprising:
abrasive grains; at least one dicarboxylic acid component selected from the group consisting of a dicarboxylic acid having 3 or less carbon atoms and a salt thereof; and water, wherein
the abrasive grains contain silica and have a positive zeta potential, and
a pH is 9.0 or less.

2. The polishing agent according to claim 1, wherein the abrasive grains contain colloidal silica.

3. The polishing agent according to claim 1, wherein an average particle diameter of the abrasive grains is more than 50 nm.

4. The polishing agent according to claim 1, wherein a content of the abrasive grains is 1 to 5% by mass.

5. The polishing agent according to claim 1, wherein the dicarboxylic acid component includes at least one selected from the group consisting of oxalic acid and a salt thereof.

6. The polishing agent according to claim 1, wherein the dicarboxylic acid component includes at least one selected from the group consisting of malonic acid and a salt thereof.

7. The polishing agent according to claim 1, wherein a content of the dicarboxylic acid component is 0.01 to 0.20% by mass.

8. The polishing agent according to claim 1, further comprising a cationic surfactant.

9. The polishing agent according to claim 8, wherein the cationic surfactant includes an ammonium salt.

10. The polishing agent according to claim 8, wherein the cationic surfactant includes an ammonium salt having one quaternary nitrogen atom.

11. The polishing agent according to claim 8, wherein the cationic surfactant includes an ammonium salt having a carbon-carbon unsaturated bond.

12. The polishing agent according to claim 1, wherein the pH is 3.0 to 4.0.

13. The polishing agent according to claim 1, wherein the pH is more than 3.0 and 4.0 or less.

14. A polishing agent comprising constituent components of the polishing agent according to any one of claims 1 to 13 stored while being divided into a first liquid and a second liquid, wherein
the first liquid contains the abrasive grains and water, and
the second liquid contains the dicarboxylic acid component and water.

15. A polishing method comprising a step of polishing a surface to be polished containing indium tin oxide by using the polishing agent according to any one of claims 1 to 13.
